# EUROPEAN PATENT APPLICATION

(11) **EP 1 798 807 A1**
(43) Date of publication of application: **20.06.2007**
(21) Application number: 06025928.0
(22) Date of filing: 14.12.2006
(51) Int. Cl.: H01Q 1/24, H03H 7/40

(54) **Apparatus for automatically matching impedance of antenna in wireless terminal and method of using the same**

(30) Priority: 14.12.2005 KR 20050123492; 22.03.2006 KR 20060026132; 26.09.2006 KR 20060093598
(71) Applicant: Samsung Electronics Co., Ltd., Suwon-si, Gyeonggi-Do (KR)
(72) Inventor: Hwang, In-Jin, Yeongtong-gu Suwon-si Gyeonggi-do (KR); Lee, Jae-Ho, Yeongtong-gu Suwon-si Gyeonggi-do (KR); Shin, Jong-Kyun, Yeongtong-gu Suwon-si Gyeonggi-do (KR); Kim, Young-Hwan, Yeongtong-gu Suwon-si Gyeonggi-do (KR); Ryu, Yeong-Moo, Yeongtong-gu Suwon-si Gyeonggi-do (KR); Kim, Hark-Sang, Yeongtong-gu Suwon-si Gyeonggi-do (KR)
(74) Representative: Lang, Johannes

(57) **Abstract**

An apparatus and method for automatically matching a frequency of an antenna in a wireless terminal are provided. The apparatus includes a duplexer for classifying frequencies transmitted/received through the antenna of the wireless terminal, transmitting the reception frequency received in the antenna to an automatic matching module, and transmitting a transmission frequency, which is received from the automatic matching module, to the antenna; the automatic matching module for automatically matching impedance for the reception frequency received from the duplexer, transmitting the impedance-matched reception frequency to an amplifier, automatically matching impedance for the transmission frequency received from the amplifier, and transmitting the impedance-matched transmission frequency to the duplexer; and a controller for controlling the automatic matching module to automatically match the impedance for the transmission/reception frequencies.

## Description

### BACKGROUND OF THE INVENTION

### Field of the Invention:

The present invention relates to an apparatus that automatically matches a frequency of an antenna in a wireless terminal. More particularly, the present invention relates to an apparatus that automatically matches impedance for a frequency of an antenna in a wireless terminal.

### Description of the Related Art:

Antenna impedance in a wireless terminal is matched when the wireless terminal is not used (for example, when the user does not hold the wireless terminal in the user's hand). However, if the user holds the wireless terminal in order to use the wireless terminal, the impedance matching for the antenna in the wireless terminal is not achieved. This causes the performance of the wireless terminal to be degraded.

Accordingly, there is a need for an improved system and method for automatically matching impedance for a frequency of an antenna in a wireless terminal.

### SUMMARY OF THE INVENTION

An aspect of exemplary embodiments of the present invention is to address at least the above problems and/or disadvantages and to provide an apparatus for automatically matching impedance for a frequency of an antenna in a wireless terminal.

In accordance with one aspect of an exemplary embodiment of the present invention, an apparatus that automatically matches a frequency of an antenna in a wireless terminal is provided. The apparatus includes a duplexer, an automatic matching module and a controller. The duplexer classifies frequencies transmitted/received through the antenna of the wireless terminal. The duplexer also transmits the reception frequency received in the antenna to an automatic matching module, and transmits a transmission frequency, which is received from the automatic matching module, to the antenna. The automatic matching module automatically matches impedance for the reception frequency received from the duplexer, transmits the impedance-matched reception frequency to an amplifier, automatically matches impedance for the transmission frequency received from the amplifier, and transmits the impedance-matched transmission frequency to the duplexer. The controller controls the automatic matching module to automatically match the impedance for the transmission/reception frequencies.

In accordance with another aspect of an exemplary embodiment of the present invention, an apparatus that automatically matches a frequency of an antenna in a wireless terminal that receives at least two communication services is provided. The apparatus includes a switching module and at least two communication service modules. The switching module is switched to at least one of two communication service modules according to a signal received in the antenna of the wireless terminal. The two communication service modules automatically match impedance for a reception frequency received through the antenna, outputs the impedance-matched reception frequency, or automatically matches impedance for a transmission frequency, and transmits the impedance-matched transmission frequency to the antenna, if the communication service modules are linked with the antenna through switching of the switching module.

According to another aspect of an exemplary embodiment of the present invention, an apparatus for automatically matching a frequency of an antenna in a wireless terminal is provided. The apparatus includes a controller, an automatic matching module and a duplexer. The controller determines operation states of the wireless terminal and controls an automatic matching module to automatically match impedance for transmission/reception frequencies of the antenna. The automatic matching module automatically matches impedance for the reception frequency received from the antenna, transmits the impedance-matched reception frequency to a duplexer, automatically matches impedance for a transmission frequency received from the duplexer, and transmits the impedance-matched transmission frequency to the antenna. The duplexer classifies the frequencies transmitted/received through the automatic matching module, transmits the reception frequency, which is received from the automatic matching module, to the amplifier, or transmits the transmission frequency, which is received from the amplifier, to the automatic matching module.

In accordance with still another aspect of an exemplary embodiment of the present invention, an apparatus is provided to automatically match a frequency of an antenna in a wireless terminal that receives at least two communication services. The apparatus includes a controller, an automatic matching module, a switching module and at least two communication service modules. The controller determines states of the wireless terminal and controls the automatic matching module to automatically match impedance for transmission/reception frequencies of the antenna. The automatic matching module automatically matches impedance for the reception frequency received from the antenna, transmits the impedance-matched reception frequency to a switching module, automatically matches impedance for a transmission frequency received from the switching module, and transmits the impedance-matched transmission frequency to the antenna. The switching module is switched to at least one of two communication service modules according to a type of a reception signal received in the antenna. The two communication service modules transmit/receive a frequency of the antenna through the automatic matching module if the two communication service modules are linked with the automatic matching module through switching of the switching module.

Other objects, advantages, and salient features of the invention will become apparent to those skilled in the art from the following detailed description, which, taken in conjunction with the annexed drawings, discloses exemplary embodiments of the invention.

### BRIEF DESCRIPTION OF THE DRAWINGS

The above and other exemplary objects, features and advantages of certain exemplary embodiments of the present invention will be more apparent from the following detailed description taken in conjunction with the accompanying drawings, in which:
FIG. 1 is a block diagram illustrating an apparatus for automatically matching the frequency of an antenna in a wireless terminal according to a first exemplary embodiment of the present invention;
FIG. 2 is a block diagram illustrating an apparatus for automatically matching impedance for a frequency of an antenna in a wireless terminal for receiving at least two communication services according to a first exemplary embodiment of the present invention;
FIG. 3 is a block diagram illustrating an apparatus for automatically matching the frequency of an antenna in a wireless terminal according to a second exemplary embodiment of the present invention;
FIG. 4 is a block diagram illustrating an apparatus for automatically performing impedance matching for an antenna frequency in a wireless terminal receiving at least two communication services according to a second exemplary embodiment of the present invention;
FIG. 5 is a circuit diagram illustrating the structure of a capacitor bank in an automatic matching module according to an exemplary embodiment of the present invention; and
FIGs. 6a to 6c are diagrams explaining automatic impedance matching for an antenna frequency in a wireless terminal according to exemplary embodiments of the present invention.

Throughout the drawings, the same drawing reference numerals will be understood to refer to the same elements, features and structures.

### DETAILED DESCRIPTION OF THE EXEMPLARY EMBODIMENTS

The matters defined in the description such as a detailed construction and elements are provided to assist in a comprehensive understanding of the embodiments of the invention. Accordingly, those of ordinary skill in the art will recognize that various changes and modifications of the embodiments described herein can be made without departing from the scope and spirit of the invention. Also, descriptions of well-known functions and constructions are omitted for clarity and conciseness.

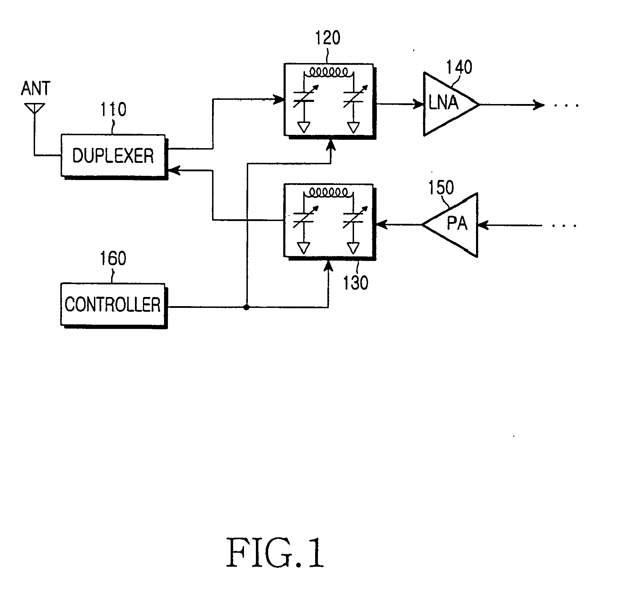

FIG. 1 is a block diagram illustrating an apparatus for automatically matching the frequency of an antenna in a wireless terminal according to a first exemplary embodiment of the present invention.

Referring to FIG. 1, the duplexer 110 separates a transmission port from a reception port through the antenna ANT of the wireless terminal, and transmits a reception frequency received in the antenna to a first automatic matching module 120 through the reception port. The duplexer 110 also transmits a transmission frequency received from a second automatic matching module 130 to the antenna ANT through the transmission port.

The controller 160 controls the overall function of the wireless terminal. According to the first exemplary embodiment of the present invention, the controller 160 controls an automatic matching module based on a predetermined optimum frequency signal value of the antenna ANT, thereby automatically matching impedance for a frequency of the antenna ANT.

The automatic matching module, which automatically matches the impedance for a frequency of an antenna, includes the first automatic matching module 120 and the second automatic matching module 130.

The first automatic matching module 120 includes a fixed inductor and variable capacitors. The first automatic matching module 120 automatically matches the impedance for the reception frequency output from the reception port of the duplexer 110 by adjusting the values of the capacitors, and then transmits the reception frequency to the first amplifier 140. The second automatic matching module 130 includes a fixed inductor and variable capacitors. The second automatic matching module 130 automatically matches the impedance for the transmission frequency, which is amplified by and output from the second amplifier 150, by adjusting the values of the capacitors, and then transmits the transmission frequency to the duplexer 110.

The first and second automatic matching modules 120 and 130 include at least one capacitor bank, respectively. The capacitor bank has a structure in which n capacitors are linked with one another.

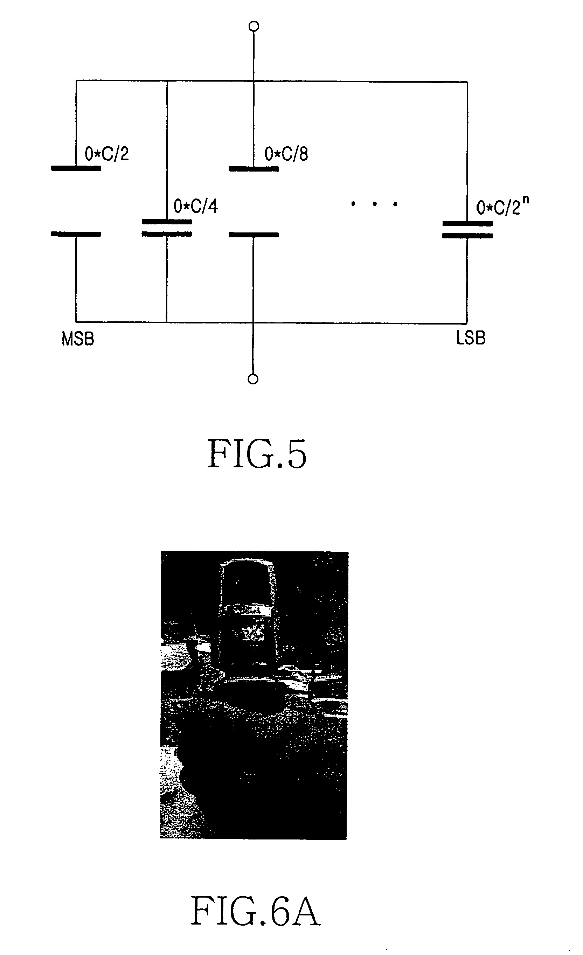

FIG. 5 illustrates one capacitor bank which has n capacitors linked with one another. Referring to FIG. 5, values of the capacitors (Cs) included in the capacitor bank may sequentially increase as C/2, C/4, C/8,..., and C/2ⁿ. Each capacitor is linked through a switch and has a value of "1" or "0" according to an on and off state thereof. The capacitors also have the total capacitance value *Cₜₒₜₐₗ* of "0**C*/2+1**C*/4+0**C*/8+...+1**C*/2*ⁿ*".

The first exemplary embodiment of the present invention will be described on the assumption that each of the first and second automatic matching modules 120 and 130 includes four capacitor banks, and each capacitor bank has eight capacitors linked with one another. Thus, one capacitor bank, according to the first exemplary embodiment of the present invention, may have 2⁸ (such as, 256) capacitor values.

Therefore, the first automatic matching module 120 performs on/off operations for corresponding capacitors under the control of the controller 160 after extracting capacitor values suitable for forming an optimum reception frequency signal from a plurality of capacitor values of the four capacitor banks, thereby automatically matching the impedance for the reception frequency. The second automatic matching module 130 also performs on/off operations for corresponding capacitors under the control of the controller 160 after capacitor values suitable for forming an optimum transmission frequency signal are extracted from a plurality of capacitor values of the four capacitor banks, thereby automatically matching the impedance for the transmission frequency.

An amplifier module amplifies a frequency signal transmitted/received through the antenna ANT, which includes the first amplifier 140 and the second amplifier 150. The first amplifier 140 amplifies and outputs the impedance-matched reception frequency output from the first automatic matching module 120. According to an exemplary implementation, the first amplifier 140 may be a Low Noise Amplifier (LNA). The second amplifier 150 also amplifies the transmission frequency to output the amplified transmission frequency to the second automatic matching module 130. According to an exemplary implementation, the second amplifier 150 may be a Power Amplifier (PA).

An operation for automatically matching the impedance for a frequency of an antenna in the wireless terminal having the structure illustrated in FIG. 1 is described below. The controller 160 detects a signal that is received through the antenna ANT of the wireless terminal. After detection, the controller 160 outputs a reception frequency signal received in the antenna ANT to the first automatic matching module 120 through the reception port of the duplexer 110. The first automatic matching module 120 performs on/off operations for corresponding capacitors under the control of the controller 160. The operations are performed after capacitor values suitable for forming an optimum reception frequency signal have been extracted from a plurality of capacitor values. This facilitates the automatic performance of impedance matching for the reception frequency. Then, the first automatic matching module 120 transmits the impedance-matched reception frequency to the first amplifier 140. Accordingly, the controller 160 controls the first amplifier 140 to amplify and output the impedance-matched reception frequency signal output from the first automatic matching module 120.

The controller 160 detects a transmission frequency signal that is generated in the wireless terminal. The controller 160 amplifies the transmission frequency signal through the second amplifier 150, and then outputs the amplified transmission frequency signal to the second automatic matching module 130. The second automatic matching module 130 performs on/off operations for corresponding capacitors under the control of the controller 160. These operations are performed after capacitor values suitable for forming an optimum transmission frequency signal are extracted from among a plurality of capacitor values. The second automatic matching module 130 automatically performs impedance matching for the transmission frequency. Then, the second automatic matching module 130 transmits the impedance-matched transmission frequency to the duplexer 110. Accordingly, the controller 160 transmits the impedance-matched transmission frequency signal, which is output from the second automatic matching module 130, to the antenna ANT through the transmission port of the duplexer 110.

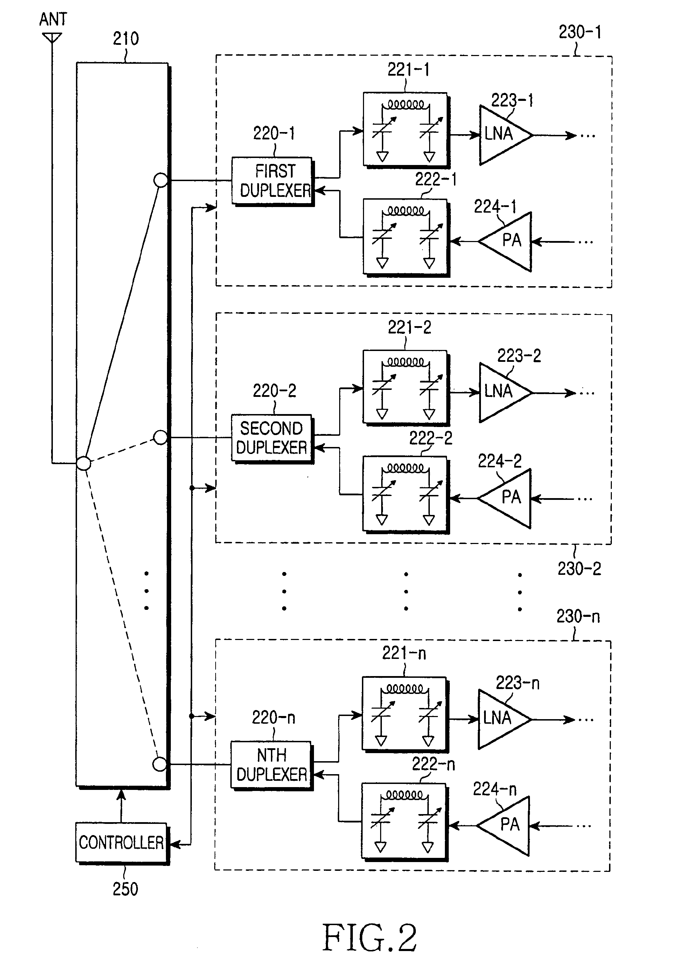

FIG. 2 is a block diagram illustrating an apparatus for automatically matching impedance for a frequency of an antenna in a wireless terminal for receiving at least two communication services according to the first exemplary embodiment of the present invention. The wireless terminal can perform at least two communication services.

Referring to FIG. 2, according to the first exemplary embodiment of the present invention, a controller 250 controls the overall function of the wireless terminal. The controller 250 controls a switching module 210 to be switched to one of at least two communication services according to the type of a reception signal received in the antenna ANT. The controller 250 also controls automatic matching modules, which are respectively included in at least two communication service modules, according to a preset optimum antenna frequency signal value. The controller 250 then automatically performs impedance matching for an antenna frequency.

The switching module 210 is switched to one of two communication service modules 230-1 to 230-n according to the type of a reception signal received in the antenna ANT of the wireless terminal under the control of the controller 250, thereby allowing a corresponding communication service to be performed.

The two communication service modules 230-1 to 230-n denote communication service modules that perform communication services such as a CDMA service, a PCS service, and a GSM service. Each of the communication service modules 230-1 to 230-n includes a duplexer, an automatic matching module, and an amplifier. The two communication service modules 230-1 to 230-n may also denote the portable Internet such as wireless LAN or WiBro, as well as CDMA, PCS, and GSM.

The first communication service module 230-1 of the communication service modules 230-1 to 230-n will be described. If the first duplexer 220-1 is linked with the antenna ANT through a switching module 210, the first duplexer 220-1 separates a transmission port from a reception port through the antenna ANT. The first duplexer 220-1 also transmits a reception frequency received in the antenna ANT to a first automatic matching module 221-1 through the reception port. The first duplexer 220-1 also transmits a transmission frequency received from a second automatic matching module 222-1 to the antenna ANT through the transmission port.

An automatic matching module, which automatically matches the impedance for a frequency of an antenna, includes the first automatic matching module 221-1 and the second automatic matching module 222-1. The first automatic matching module 221-1 includes a fixed inductor and variable capacitors. This first automatic matching module 221-1 automatically matches the impedance for a received frequency output from the reception port of the first duplexer 220-1, and then transmits the received frequency to the first amplifier 223-1. The second automatic matching module 222-1 also includes a fixed inductor and variable capacitors and automatically matches the impedance for a transmission frequency amplified by and output from the second amplifier 224-1, and then transmits the transmission frequency to the first duplexer 220-1.

Each of the first and second automatic matching modules 221-1 and 222-1 include at least one capacitor bank. The capacitor bank has n capacitors linked with each other as illustrated in FIG. 5. Four capacitor blanks as illustrated in FIG. 1 are assumed to be included in each of the first and second automatic matching modules 221-1 and 222-1. Each capacitor bank has eight capacitors (Cs) linked with one another.

Therefore, the first automatic matching module 221-1 performs on/off operations for corresponding capacitors under the control of the controller 250 after suitable capacitor values have been extracted to form an optimum reception frequency signal from a plurality of capacitor (C) values of the four capacitor banks. This facilitates automatic impedance matching for the reception frequency. The second automatic matching module 222-1 performs on/off operations for corresponding capacitors under the control of the controller 250 after suitable capacitor values have been extracted to form an optimum transmission frequency signal from a plurality of capacitor (C) values of the four capacitor banks. This facilitates automatic impedance matching for the transmission frequency.

An amplifier module amplifies transmission/reception frequency signals transmitted/received through the antenna, which includes the first amplifier 223-1 and the second amplifier 224-1. The first amplifier 223-1 amplifies and outputs the impedance-matched reception frequency output from the first automatic matching module 221-1. According to an exemplary implementation, the first amplifier 223-1 may be a LNA. The second amplifier 224-1 also amplifies the transmission frequency to output the amplified transmission frequency to the second automatic matching module 222-1. According to an exemplary implementation, the second amplifier 224-1 may be a PA.

The second duplexer 220-2 to the nth duplexer 220-n, automatic matching modules 221-2 to 221-n and 222-2 to 222-n, and amplifiers 223-1 to 223-n and 224-1 to 224-n included in the second communication service module 230-2 to the nth communication service module 230-n, respectively, perform corresponding communication service functions while performing functions similar to those of the first duplexer 220-1, the automatic matching modules 221-1 and 222-1, and the amplifiers 223-1 and 224-1 included in the first communication service module 230-1.

An operation for automatically matching impedance for a frequency of an antenna in the wireless terminal including the structure illustrated in FIG. 2 will be described. The controller 250 of the wireless terminal detects whether a frequency signal for a communication service (for example a CDMA communication service), which can be performed by the first communication service module 230-1, is received in the wireless terminal capable of performing two or more communication services. The controller 250 of the wireless terminal also controls the switching module 210 to be switched to the first communication service module 230-1. The controller 250 detects whether the switching module 210 is switched to the first communication service module 230-1 and outputs the reception frequency signal received in the antenna ANT to the first automatic matching module 221-1 through the reception port of the first duplexer 220-1. The first automatic matching module 221-1 performs on/off operations for corresponding capacitors under the control of the controller 250. These operations are performed after suitable capacitor values for forming an optimum reception frequency signal are extracted from a plurality of capacitor values of the four capacitor banks, thereby automatically performing impedance matching for the reception frequency. Then, the first automatic matching module 221-1 transmits the reception frequency to the first amplifier 223-1. Accordingly, the controller 250 controls the first amplifier 223-1 to amplify and output the impedance-matched reception frequency signal output from the first automatic matching module 221-1.

The controller 250 detects the generation of a transmission frequency signal in the CDMA communication service, amplifies the transmission frequency signal through the second amplifier 224-1, and then outputs the amplified transmission frequency signal to the second automatic matching module 222-1. The second automatic matching module 222-1 performs on/off operations for corresponding capacitors under the control of the controller 250 after suitable capacitor values for forming an optimum reception frequency signal are extracted from a plurality of capacitor values, thereby automatically matching the impedance for the transmission frequency. Then, the second automatic matching module 222-1 transmits the transmission frequency to the first duplexer 220-1. Accordingly, the controller 250 transmits the impedance-matched transmission frequency output from the second automatic matching module 222-1 to the antenna through the transmission port of the first duplexer 220-1.

Impedance matching for an antenna frequency can be automatically achieved based on the optimum frequency signal value. The impedance matching is achieved by means of the wireless terminals constructed as illustrated in FIGs. 1 and 2.

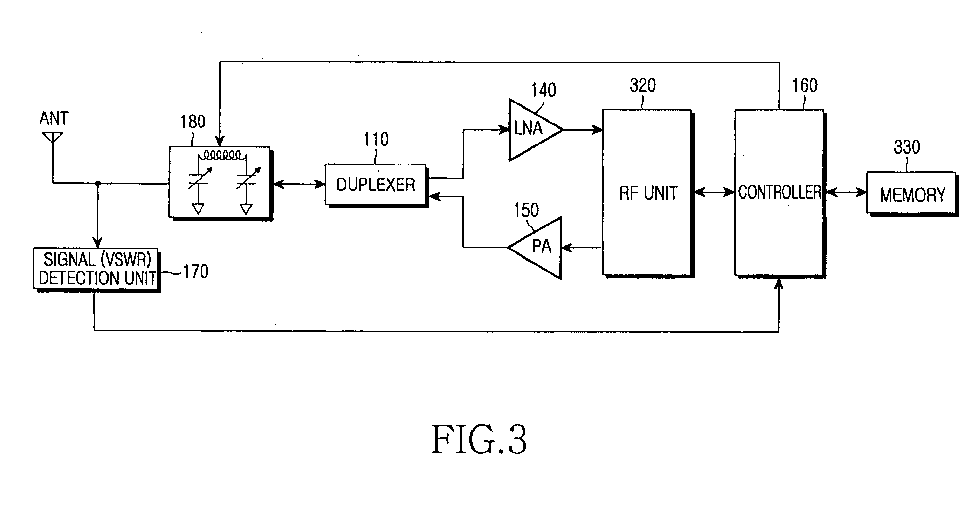

FIG. 3 is a block diagram illustrating an apparatus for automatically matching the frequency of an antenna in a wireless terminal according to a second exemplary embodiment of the present invention.

Referring to FIG. 3, a signal detection unit 170 detects a signal received in the antenna ANT and outputs the signal to the controller 160. In detail, the signal detection unit 170 corresponds to a voltage standing wave ratio (VSWR) detection module used for detecting a VSWR signal including a magnitude signal and a phase signal received through the antenna ANT, and then outputting the VSWR signal to the controller 160.

The controller 160 controls the overall function of the wireless terminal. According to the second exemplary embodiment of the present invention, if the VSWR signal is output from the signal detection unit 170, the controller 160 determines a first operation state of the wireless terminal according to the type of received VSWR signal through a first automatic matching table stored in the memory 330. If the first operation state of the wireless terminal is determined, the controller 160 extracts the optimum antenna frequency signal value suitable for the automatic matching corresponding to the first operation state of the wireless terminal through the first automatic matching table. Then, the controller 160 controls an automatic matching module 180 according to the optimum antenna frequency signal value suitable for the automatic matching extracted through the first automatic matching table, thereby automatically matching impedance for the antenna frequency.

The first operation state of the wireless terminal is an operation state determined through the VSWR signal received from the signal detection unit 170. The first operation state includes a down idle mode, a down held mode, an open idle mode and an open held mode. In the down idle mode, a user is not holding the wireless terminal and a folder of the wireless terminal is closed. In the down held mode, a user holds the wireless terminal and the folder of the wireless terminal is closed. In the open idle mode, a user is not holding the wireless terminal and the folder of the wireless terminal is opened. In the open held mode, a user holds the wireless terminal and the folder of the wireless terminal is opened.

The controller 160 determines the second operation state of the wireless terminal through the function operation of the wireless terminal. The controller 160 also extracts an optimum antenna frequency signal value for automatic matching corresponding to the second operation state of the wireless terminal through the second automatic matching table stored in the memory 330. The controller 160 controls the automatic matching module 180 based on the optimum antenna frequency signal value for automatic matching extracted through the second automatic matching table, thereby automatically matching the impedance for the antenna frequency.

The second operation state of the wireless terminal represents an operation state in which an additional device is connected to the wireless terminal for communication performance or an operation state in which a specific operation is performed or set in the wireless terminal. The second operation state of the wireless terminal includes the opening/closing of a folder of the wireless terminal, the use of a hands free device, the use of a Bluetooth headset, key input for communication performance, and automatic communication connection, among others.

The opening/closing of the folder of the wireless terminal is detected by a folder opening/closing detector (not shown) provided in the wireless terminal, and a predetermined detection signal is output to the controller 160. Accordingly, the controller 160 can determine the opening/closing state of the folder of the wireless terminal through the detection signal output from the folder opening/closing detector.

The use of the hands free device can be determined by the controller 160 through a signal (high, low) output from a pull-up resistor connected to the headset connection port of the wireless terminal. The controller 160 detects the voltage of a high signal output from the pull-up resistor. However, the controller 160 can determine the use of the hands free device if the plug of the headset for the use of the hands free device is inserted into the connection jack of the wireless terminal and a low signal is output from the pull-up resistor.

The use of the Bluetooth headset can be determined by the controller 160 when the Bluetooth headset is turned on in an ID setting mode, and the Bluetooth headset is detected in the Bluetooth mode of the wireless terminal.

The key input for communication performance can be determined by the controller 160 through a key input operation for responding to an incoming call generated in the wireless terminal. The automatic communication connection can be determined by the controller 160 through the setup of a user for automatic connection for an incoming call generated in the wireless terminal.

The memory 330 may include a program memory and a data memory. The program memory stores programs that control the general operation of the wireless terminal, and the data memory temporarily stores data generated during the execution of the programs.

The memory 330 stores the automatic matching table according to the second exemplary embodiment of the present invention, and the automatic matching table includes the first automatic matching table and the second automatic matching table. The first automatic matching table stores the type of VSWR signal, the type of the first operation state of the wireless terminal corresponding to the type of VSWR signal, and the optimum antenna frequency signal value for automatic matching corresponding to the first operation state of the wireless terminal. The second automatic matching table stores the type of second operation state of the wireless terminal, and the optimum antenna frequency signal value for automatic matching corresponding to the second operation state of the wireless terminal.

The automatic matching module 180 automatically performs impedance matching for the antenna frequency and includes a fixed inductor and variable capacitors. After automatically matching impedance for the reception frequency output from the antenna by adjusting values of the capacitors (Cs), the automatic matching module 180 transmits the reception frequency to the first amplifier 140 through the reception port of the duplexer 110. After the automatic matching module 180 automatically matches impedance for a transmission frequency received therein through the transmission port of the duplexer 110 by adjusting values of the capacitors (Cs), the automatic matching module 180 also transmits the transmission frequency to the antenna ANT.

The automatic matching module 180 includes at least one capacitor bank in which n capacitors are linked with one another.

FIG. 5 illustrates one capacitor bank having n capacitors linked with each another. Referring to FIG. 5, values of the capacitors (Cs) included in the capacitor bank may sequentially increase as C/2, C/4, C/8, ..., and C/2 . Each capacitor is linked through a switch and has a value of "1" or "0" according to its existing on and off state. The capacitors also have the total capacitance value *Cₜₒₜₐₗ* of "0**C*/2+1**C*/4+0**C*/8+ ..+1**C*/2*ⁿ*".

The second exemplary embodiment of the present invention will be described on the assumption that the automatic matching module 180 includes four capacitor banks, and each capacitor bank has eight capacitors linked with one another. According to the second exemplary embodiment of the present invention, one capacitor bank may have 2 (i.e., 256) capacitor values.

Therefore, the automatic matching module 180 performs on/off operations for corresponding capacitors under the control of the controller 160 after extracting capacitor values suitable for forming optimum transmission/reception frequency signals from a plurality of capacitor values of the four capacitor banks, thereby automatically matching the impedance for the transmission/reception frequencies.

The duplexer 110 separates a transmission port from a reception port through the antenna ANT of the wireless terminal, and transmits a reception frequency received through the automatic matching module 180 to the first amplifier 140. Further, the duplexer 110 transmits a transmission frequency received from a second amplifier 150 to the automatic matching module 180 through the transmission port.

An amplifier module amplifies a frequency signal transmitted/received through the antenna ANT, which includes the first amplifier 140 and the second amplifier 150. The first amplifier 140 amplifies and outputs the reception frequency output from the reception port of the duplexer 110. According to an exemplary implementation, the first amplifier 140 may be a LNA. The second amplifier 150 also amplifies the transmission frequency output from the RF unit 320 to output the transmission frequency to the transmission port of the duplexer 110. According to an exemplary implementation, the second amplifier 150 may be a PA.

The RF unit 320 includes an RF receiver and an RF transmitter. The RF receiver down-converts signals received from the first amplifier 140. The RF transmitter up-converts the frequency of transmitted signals and outputs the signals to the second amplifier 150, etc.

Hereinafter, an operation for automatically performing impedance matching for an antenna frequency in the wireless terminal including the structure illustrated in FIG. 3 will be described. If a signal is received through the antenna ANT of the wireless terminal, the controller 160 of the wireless terminal detects the reception of the signal and outputs the received signal to the automatic matching module 180. According to an exemplary implementation, the controller 160 determines a state of the wireless terminal based on a signal output from the signal detection unit 170, thereby controlling the automatic matching module 180.

If the signal detection unit 170 detects a VSWR signal received from the antenna of the wireless terminal and outputs the VSWR signal to the controller 160, the controller 160 determines the type of first operation state of the wireless terminal corresponding to the VSWR signal received from the signal detection unit 170 and extracts the optimum antenna frequency signal value for automatic matching corresponding to the type of first operation state of the wireless terminal by using the first automatic matching table. The controller 160 controls the automatic matching module 180 based on the optimum antenna frequency signal value extracted through the first automatic matching table, such that impedance matching for the received frequency can be automatically achieved.

If a signal is received through the antenna of the wireless terminal, the controller 160 of the wireless terminal detects the reception of the signal and outputs the received signal to the automatic matching module 180. According to an exemplary implementation, the controller 160 determines a second operation state of the wireless terminal in order to determine the current performance of a function operation for communication performance in the wireless terminal.

The second operation state of the wireless terminal corresponds to the opening/closing of a folder of the wireless terminal, the use of a hands free device, the use of a Bluetooth headset, or key input and setup for automatic communication connection. If the second operation state of the wireless terminal is determined, the controller 160 extracts the optimum antenna frequency signal value for automatic matching corresponding to the type of the second operation state of the wireless terminal by using the second automatic matching table.

The controller 160 controls the automatic matching module 180 according to the optimum antenna frequency signal value extracted through the second automatic matching table, such that impedance matching for the received frequency received from the antenna can be automatically achieved.

The automatic matching module 180 performs on/off operations for corresponding capacitors under the control of the controller 160 after values of capacitors suitable for forming the optimum reception frequency signal are extracted from among a plurality of capacitor values, thereby automatically matching the impedance for the reception frequency. Then, the automatic matching module 180 transmits the reception frequency to the first amplifier 140 through the reception port of the duplexer 110. Accordingly, the controller 160 controls the first amplifier 140 to amplify and output the impedance-matched reception frequency signal output from the duplexer 110.

If the transmission frequency signal is generated in the wireless terminal, the controller 160 detects the transmission frequency signal, and the second amplifier 150 amplifies the transmission frequency signal and outputs the amplified transmission frequency signal to the automatic matching module 180 through the transmission port of the duplexer 110. According to an exemplary implementation, the controller 160 determines a state of the wireless terminal based on a signal output from the signal detection unit 170 to control the automatic matching module 180.

If the signal detection unit 170 detects a VSWR signal received from the antenna of the wireless terminal and outputs the VSWR signal to the controller 160, the controller 160 determines a state of the wireless terminal corresponding to the VSWR signal received from the signal detection unit 170 and extracts the optimum antenna frequency signal value for automatic matching corresponding to the state of the wireless terminal by using the first automatic matching table. The controller 160 controls the automatic matching module 180 based on the optimum antenna frequency signal value which is extracted through the first automatic matching table to automatically display impedance matching for the transmission frequency.

If the transmission frequency signal is generated in the wireless terminal, the controller 160 detects the transmission frequency signal, and the second amplifier 150 amplifies the transmission frequency signal and outputs the amplified transmission frequency signal to the automatic matching module 180 through the transmission port of the duplexer 110. According to an exemplary implementation, the controller 160 determines the second operation state of the wireless terminal.

The second operation state of the wireless terminal corresponds to the opening/closing of a folder of the wireless terminal, the use of a hands free device, the use of a Bluetooth headset, or key input and setup for automatic communication connection. If the second operation state of the wireless terminal is determined, the controller 160 extracts the optimum antenna frequency signal value for automatic matching corresponding to the type of second operation state of the wireless terminal by using the second automatic matching table.

The controller 160 controls the automatic matching module 180 according to the optimum antenna frequency signal value extracted through the second automatic matching table to automatically display impedance matching for the transmission frequency.

The automatic matching module 180 performs on/off operations for corresponding capacitors under the control of the controller 160 after extracting values of capacitors suitable for forming the optimum transmission frequency signal from a plurality of capacitor values, thereby automatically matching the impedance for the transmission frequency. Then, the automatic matching module 180 transmits the impedance-matched transmission frequency to the antenna.

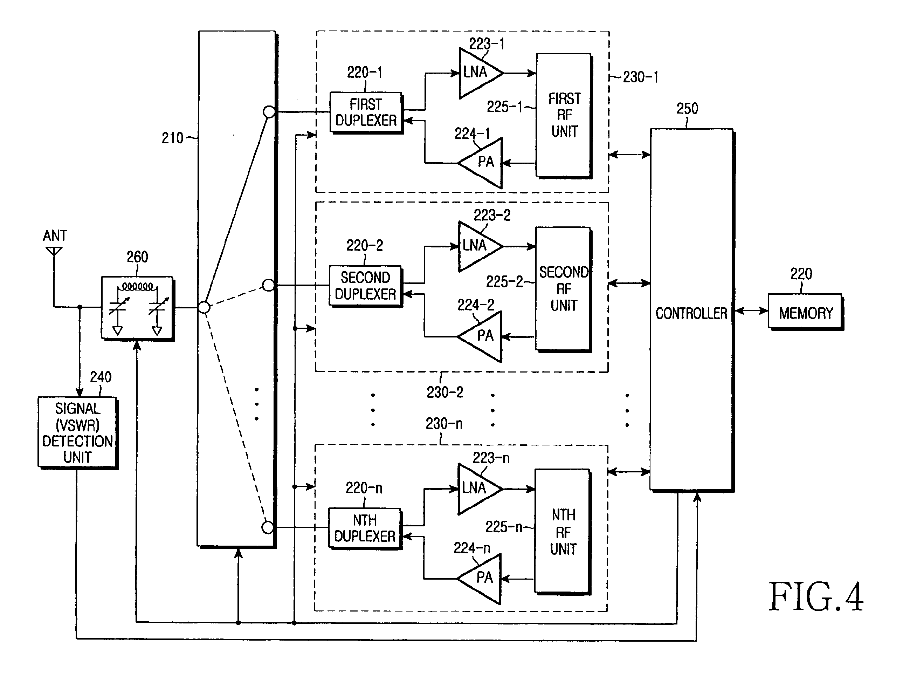

FIG. 4 is a block diagram illustrating an apparatus capable of automatically performing impedance matching for an antenna frequency in the wireless terminal receiving at least two communication services according to the second exemplary embodiment of the present invention. According to an exemplary implementation, the wireless terminal can perform at least two communication services.

Referring to FIG. 4, a signal detection unit 240 detects a signal received from the antenna ANT and outputs the received signal to the controller 250. The signal detection unit 240 corresponds to a VSWR detection module, detects a VSWR signal including a magnitude signal and a phase signal, which is received through the antenna ANT, and then outputs the VSWR signal to the controller 250.

The controller 250 controls the overall function of the wireless terminal. According to the second exemplary embodiment of the present invention, the controller 250 controls the switching module 210 to be switched to one of at least two communication services according to the type of a reception signal received in the antenna. If a VSWR signal is output from the signal detection unit 240, the controller 250 determines the first operation state of the wireless terminal according to the type of the received VSWR signal by using a first automatic matching table stored in a memory 220. If the first operation state of the wireless terminal is determined, the controller 250 extracts the optimum antenna frequency signal value suitable for automatic matching corresponding to the first operation state of the wireless terminal by using the first automatic matching table. The controller 250 controls an automatic matching module 260 based on the optimum antenna frequency signal value extracted through the automatic matching table, thereby automatically performing impedance matching for the antenna frequency.

The first operation state of the wireless terminal is an operation state determined through the VSWR signal received from the signal detection unit 240. The first operation state includes a down idle mode, a down held mode, an open idle mode and an open held mode. In the down idle mode, a user is not holding the wireless terminal and a folder of the wireless terminal is closed. A user holds the wireless terminal and the folder of the wireless terminal is closed in the down held mode. In an open idle mode, a user is not holding the wireless terminal and the folder of the wireless terminal is opened. In an open held mode, a user holds the wireless terminal and the folder of the wireless terminal is opened.

The controller 250 determines the second operation state of the wireless terminal through the function operation of the wireless terminal, and extracts an optimum antenna frequency signal value for automatic matching corresponding to the second operation state of the wireless terminal through the second automatic matching table stored in the memory 220. The controller 250 controls the automatic matching module 260 based on the optimum antenna frequency signal value for automatic matching extracted through the second automatic matching table, thereby automatically matching the impedance for the antenna frequency.

The second operation state of the wireless terminal represents an operation state in which an additional device is connected to the wireless terminal for communication performance, or in which a specific operation is performed or set in the wireless terminal. The second operation state of the wireless terminal includes the opening/closing of a folder of the wireless terminal, the use of a hands free device, the use of a Bluetooth headset, key input for communication performance, automatic communication connection, etc.

The opening/closing of the folder of the wireless terminal is detected by a folder opening/closing detector (not shown) provided in the wireless terminal, and a predetermined detection signal is output to the controller 250. Accordingly, the controller 250 can determine the opening/closing state of the folder of the wireless terminal through the detection signal output from the folder opening/closing detector.

The use of the hands free device can be determined by the controller 250 through a signal (high, low) output from a pull-up resistor connected to the headset connection port of the wireless terminal. The controller 250 detects the voltage of a high signal output from the pull-up resistor. If the plug of the headset is inserted into the connection jack of the wireless terminal and a low signal is output from the pull-up resistor, the controller 250 can determine the use of the hands free device.

The use of the Bluetooth headset can be determined by the controller 250 when the Bluetooth headset is turned on in an ID setting mode, and the Bluetooth headset is detected in the Bluetooth mode of the wireless terminal.

The key input for communication performance can be determined by the controller 250 through a key input operation for responding to an incoming call generated in the wireless terminal. The automatic communication connection can be determined by the controller 250 through the setup of a user for automatic connection for an incoming call generated in the wireless terminal.

The memory 220 may include a program memory and a data memory. The program memory stores programs for controlling the general operation of the wireless terminal, and the data memory temporarily stores data generated during the execution of the programs.

The memory 220 stores the automatic matching table according to the second exemplary embodiment of the present invention, and the automatic matching table includes the first automatic matching table and the second automatic matching table. The first automatic matching table stores the type of VSWR signal, the type of the first operation state of the wireless terminal corresponding to the type of the VSWR signal, and the optimum antenna frequency signal value for automatic matching corresponding to the first operation state of the wireless terminal. The second automatic matching table stores the type of second operation state of the wireless terminal, and the optimum antenna frequency signal value for automatic matching corresponding to the second operation state of the wireless terminal.

The automatic matching module 260 automatically performs impedance matching for the antenna frequency under the control of the controller 250 and includes a fixed inductor and variable capacitors. The automatic matching module 260 automatically performs impedance matching for transmission/reception frequencies of a corresponding communication service module linked with the antenna from among one or more communication service modules by adjusting capacitor (C) values.

The automatic matching module 260 includes at least one capacitor bank in which n capacitors are linked with one another as illustrated in FIG. 5. In addition, the automatic matching module 260 includes four capacitor banks as illustrated in FIG. 3, and each capacitor bank includes eight capacitors (Cs) linked with one another.

Therefore, the automatic matching module 260 performs on/off operations for corresponding capacitors under the control of the controller 250 after extracting capacitor values suitable for forming optimum transmission/reception frequency signals from a plurality of capacitor (C) values of the four capacitor banks, thereby automatically matching the impedance for the transmission/reception frequencies of a corresponding communication service module linked with the antenna ANT.

The switching module 210 is switched to corresponding communication service modules 232-1 to 232-n based on the type of a reception signal received in the antenna ANT of the wireless terminal, such that a corresponding communication service can be performed.

The communication service modules 230-1 to 230-n denote communication service modules performing communication services such as a CDMA service, a PCS service, and a GSM service. Each of the communication service modules 230-1 to 230-n includes a duplexer and an amplifier. The communication service modules 230-1 to 230-n may also denote the portable Internet access configurations such as wireless LAN or WiBro as well as CDMA, PCS, and GSM.

According to an exemplary implementation, the first communication service module 230-1 of the communication service modules 230-1 to 230-n will be described. If the first duplexer 220-1 is linked with the antenna ANT through the switching module 210, the first duplexer 220-1 separates a transmission port from a reception port through the antenna ANT. In addition, the first duplexer 220-1 transmits a reception frequency received from the automatic matching module 260 to a first amplifier 223-1. The first duplexer 220-1 also transmits a transmission frequency, which is received from the second amplifier 224-1, to the automatic matching module 260 switched through the switching module 210.

An amplifier module amplifies a frequency signal transmitted/received through the antenna ANT, which includes the first amplifier 223-1 and the second amplifier 224-1. The first amplifier 223-1 amplifies and outputs the reception frequency output from the reception port of the duplexer 220-1. According to an exemplary implementation, the first amplifier 223-1 may be a LNA. The second amplifier 224-1 amplifies the transmission frequency output from the first RF unit 225-1 to output the transmission frequency to the transmission port of the duplexer 220-1. According to an exemplary implementation, the second amplifier 224-1 may be a PA.

The RF unit 225-1 includes an RF receiver and an RF transmitter. The RF receiver down-converts signals received from the first amplifier 223-1 and an RF transmitter up-converts the frequency of transmitted signals and outputs the signals to the second amplifier 224-1, etc.

The second duplexer 220-2 to the nth duplexer 220-n, amplifiers 223-1 to 223-n and 224-1 to 224-n, and second RF unit 225-2 to nth RF unit 225-n included in the second communication service module 230-2 to the nth communication service module 230-n, respectively, perform corresponding communication service functions while performing functions similar to those of the first duplexer 220-1, the amplifiers 223-1 and 224-1, and the first RF unit 225-1 included in the first communication service module 230-1.

An operation for automatically matching impedance for a frequency of an antenna in the wireless terminal including the structure illustrated in FIG. 4 will be described. A frequency signal for a communication service (for example a CDMA communication service), which can be performed by the first communication service module 230-1 may be received in the wireless terminal capable of performing two or more communication services. The controller 250 of the wireless terminal detects the receipt of this frequency signal for the communication service, outputs the reception frequency signal received in the antenna to the automatic matching module 260, and controls the switching module 210 to be switched to the first communication service module 230-1. According to an exemplary implementation, the controller 250 controls the automatic matching module 260 by determining the first operation state of the wireless terminal based on a signal output from the signal detection unit 240.

If the signal detection unit 240 detects a VSWR signal received from the antenna ANT of the wireless terminal and outputs the VSWR signal to the controller 250, the controller 250 determines the first operation state of the wireless terminal corresponding to the VSWR signal received from the signal detection unit 240 and extracts the optimum antenna frequency signal value for automatic matching corresponding to the first operation state of the wireless terminal by using the first automatic matching table. The controller 250 controls the automatic matching module 260 based on the optimum antenna frequency signal value for the automatic matching extracted by using the first automatic matching table, such that the impedance matching for the reception frequency can be achieved.

If a frequency signal which is capable of being performed by the first communication service module 230-1 is received through the antenna of the wireless terminal, the controller 250 detects the reception of the frequency signal, outputs the received frequency signal to the automatic matching module 260, and controls the switching module 210 to be switched to the first communication service module 230-1. According to an exemplary implementation, the controller 250 determines the second operation state of the wireless terminal in order to determine a function operation being currently performed for communication performance in the wireless terminal.

The second operation state of the wireless terminal corresponds to the opening/closing of a folder of the wireless terminal, the use of a hands free device, the use of a Bluetooth headset, or key input and setup for automatic communication connection. If the second operation state of the wireless terminal is determined, the controller 250 extracts the optimum antenna frequency signal value for automatic matching corresponding to the type of second operation state of the wireless terminal by using the second automatic matching table.

The controller 250 controls the automatic matching module 260 based on the optimum antenna frequency signal value extracted through the second automatic matching table, such that impedance matching for the received frequency received from the antenna can be automatically achieved.

Therefore, the automatic matching module 260 performs on/off operations for corresponding capacitors under the control of the controller 250 once capacitor values suitable for forming an optimum reception frequency signal are extracted from a plurality of capacitor (C) values, thereby automatically performing the impedance matching for the reception frequency. Then, the automatic matching module 260 transmits the impedance-matched reception frequency to the first amplifier 223-1 through the reception port of the first duplexer 220-1 in the first communication service module 230-1 to which the switching module 210 has been switched. Accordingly, the controller 250 controls the first amplifier 223-1 to amplify and output the impedance-matched reception frequency signal output from the first duplexer 220-1.

If the transmission frequency signal is generated in the first communication service module 230-1, the controller 250 detects the transmission frequency signal, controls the switching module 210 to be switched to the first communication service module 230-1, amplifies the transmission frequency signal through the second amplifier 224-1, and then outputs the amplified transmission frequency signal to the automatic matching module 260 through the transmission port of the first duplexer 220-1. According to an exemplary implementation, the controller 250 determines the first operation state of the wireless terminal based on a signal output from the signal detection unit 240 to control the automatic matching module 260.

If the signal detection unit 240 detects a VSWR signal received from the antenna ANT of the wireless terminal and outputs the VSWR signal to the controller 250, the controller 250 determines the first operation state of the wireless terminal corresponding to the VSWR signal, and extracts the optimum antenna frequency signal value for automatic matching corresponding to the first operation state of the wireless terminal by using the first matching table. The controller 250 controls the automatic matching module 260 according to the optimum antenna frequency for the automatic matching extracted through the automatic matching table, to achieve automatic impedance matching for the transmission frequency.

If a transmission frequency signal is generated in the first communication service module 230-1, the controller 250 detects the transmission frequency signal, controls the switching module 210 to be switched to the first communication service module 230-1, amplifies the transmission frequency signal through the second amplifier 224-1, and then outputs the amplified transmission frequency signal to the automatic matching module 260 through the transmission port of the duplexer 230-1. According to an exemplary implementation, the controller 250 determines the second operation state of the wireless terminal. The second operation state of the wireless terminal corresponds to the opening/closing of a folder of the wireless terminal, the use of a hands free device, the use of a Bluetooth headset, or key input and setup for automatic communication connection. If the second operation state of the wireless terminal is determined, the controller 250 extracts the optimum antenna frequency signal value for automatic matching corresponding to the type of the second operation state of the wireless terminal by using the second automatic matching table.

The controller 250 controls the automatic matching module 260 based on the optimum antenna frequency signal value extracted through the second automatic matching table, such that impedance matching for the transmission frequency can be automatically achieved.

The automatic matching module 260 performs on/off operations for corresponding capacitors under the control of the controller 250 once values of capacitors suitable for forming the optimum transmission frequency signal are extracted from a plurality of capacitor values, thereby automatically matching the impedance for the transmission frequency. Then, the automatic matching module 260 transmits the impedance-matched transmission frequency to the antenna ANT.

FIG. 4 illustrates impedance matching for transmission/reception antennas of at least one communication service module. According to an exemplary implementation, the impedance matching is achieved through one automatic matching module and it is also possible to provide an automatic matching module for each communication service.

Impedance matching for the antenna frequency can be automatically achieved according to the current operation states of the wireless terminals which have constructions as illustrated in FIGs. 3 and 4.

FIGs. 6a to 6c are diagrams explaining automatic impedance matching for an antenna frequency in the wireless terminal according to the exemplary embodiments of the present invention.

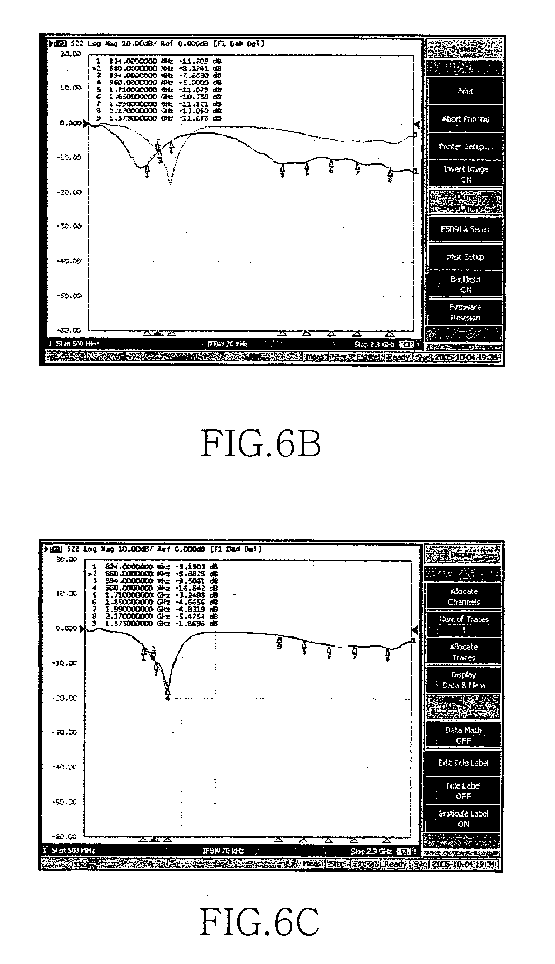

FIG. 6a illustrates a wireless terminal in an open held mode in which a user holds the wireless terminal and the folder thereof is opened. When the wireless terminal is in an open held mode, antenna impedance is mismatched as illustrated in the plots of FIG. 6b. According to the exemplary embodiments of the present invention, antenna impedance is automatically matched as illustrated in of FIG. 6c in the wireless terminals which have the constructions as illustrated in FIGs. 1 to 4, so that it is possible to prevent a mismatch in antenna impedance.

In FIGs. 6b and 6c, x and y axes represent a frequency and a reflection coefficient ( ; gamma), respectively. According to an exemplary implementation, the reflection coefficient denotes an index obtained by calculating the amount of reflection caused by an impedance difference on the basis of the ratio of reflection voltage with respect to input voltage in a predetermined connection port. The reflection coefficient denotes the amount of reflection based on the amount of the input. As the reflection coefficient decreases, the amount of the reflection decreases. A plurality of values illustrated in graphs of FIGs. 6b and 6c represent log scale (dB) values of power corresponding to reflection coefficients at predetermined points marked in the graphs.

According to an apparatus for automatically matching impedance for the antenna frequency of a wireless terminal based on an exemplary embodiment of the present invention as described above, it is possible to prevent the impedance mismatching for an antenna frequency even when a user holds the wireless terminal in the user's hand. In addition, it is possible to prevent performance degradation of the wireless terminal due to both changes in the VSWR of an antenna and the impedance mismatching of the antenna. The noise figure of a LNA and the adjacent channel power ratio (ACPR) margin of a PA can be simultaneously improved, and an efficient operation is possible in a multi-band. Various operation states in which the wireless terminal is used are determined, matching is achieved using optimum matching values based on the operation states, and radiation performance is not deteriorated. This makes it possible to completely ensure performance against various situations in which radiation performance is deteriorated due to a user's hand or the human body.

While the present invention has been shown and described with reference to certain exemplary embodiments thereof, it will be understood by those skilled in the art that various changes in form and details may be made therein without departing from the spirit and scope of the invention as defined by the appended claims and their equivalents.

## Claims

1. An apparatus for automatically matching a frequency of an antenna in a wireless terminal, the apparatus comprising:
a duplexer for classifying frequencies transmitted/received through the antenna of the wireless terminal, transmitting a reception frequency received in the antenna to an automatic matching module, and transmitting a transmission frequency, which is received from the automatic matching module, to the antenna;
the automatic matching module for automatically matching impedance for the reception frequency received from the duplexer, transmitting the impedance-matched reception frequency to an amplifier, automatically matching impedance for the transmission frequency received from the amplifier, and transmitting the impedance-matched transmission frequency to the duplexer; and
a controller for controlling the automatic matching module to automatically match the impedance for the transmission/reception frequencies.

2. The apparatus as claimed in claim 1, wherein the controller controls the automatic matching module to automatically match the impedance for the transmission/reception frequencies according to an antenna frequency signal value.

3. The apparatus as claimed in claim 1, wherein the automatic matching module comprises:
a first automatic matching module for automatically matching the impedance for the reception frequency; and
a second automatic matching module for automatically matching the impedance for the transmission frequency.

4. The apparatus as claimed in claim 1, wherein the automatic matching module comprises a fixed inductor and a variable capacitor.

5. The apparatus as claimed in claim 1, wherein the amplifier comprises:
a first amplifier for amplifying and for outputting a signal comprising the reception frequency received from the automatic matching module; and
a second amplifier for amplifying a signal comprising the transmission frequency and transmitting the amplified signal to the automatic matching module.

6. An apparatus for automatically matching a frequency of an antenna in a wireless terminal receiving at least two communication services, the apparatus comprising:
a switching module that is switched to one of at least two communication service modules according to a signal received in the antenna of the wireless terminal; and
said at least two communication service modules for automatically matching impedance for a reception frequency received through the antenna, outputting the impedance-matched reception frequency, and automatically matching impedance for a transmission frequency, and transmitting the impedance-matched transmission frequency to the antenna, if the communication service modules are linked with the antenna through switching of the switching module.

7. The apparatus as claimed in claim 6, wherein each of said at least two communication service modules comprises:
a duplexer for classifying frequencies transmitted/received through the antenna, transmitting the reception frequency received in the antenna to an automatic matching module, and transmitting a transmission frequency, which is received from the automatic matching module, to the antenna;
the automatic matching module for automatically matching impedance for the reception frequency received from the duplexer, transmitting the impedance-matched reception frequency to an amplifier, automatically matching impedance for the transmission frequency received from the amplifier, and transmitting the impedance-matched transmission frequency to the duplexer; and
a controller for controlling the automatic matching module to automatically match the impedance for the transmission/reception frequencies.

8. The apparatus as claimed in claim 7, wherein the controller controls the automatic matching module to automatically match the impedance for the transmission/reception frequencies according to an antenna frequency signal value.

9. The apparatus as claimed in claim 7, wherein the automatic matching module comprises:
a first automatic matching module for automatically matching the impedance for the reception frequency; and
a second automatic matching module for automatically matching the impedance for the transmission frequency.

10. The apparatus as claimed in claim 7, wherein the automatic matching module comprises a fixed inductor and a variable capacitor.

11. The apparatus as claimed in claim 7, wherein the amplifier comprises:
a first amplifier for amplifying and for outputting a signal comprising the reception frequency received from the automatic matching module; and
a second amplifier for amplifying a signal comprising the transmission frequency to transmit the amplified signal to the automatic matching module.

12. An apparatus for automatically matching a frequency of an antenna in a wireless terminal, the apparatus comprising:
a controller for determining operation states of the wireless terminal and controlling an automatic matching module to automatically match impedance for transmission/reception frequencies of the antenna;
the automatic matching module for automatically matching impedance for the reception frequency received from the antenna, transmitting the impedance-matched reception frequency to a duplexer, automatically matching impedance for a transmission frequency received from the duplexer, and transmitting the impedance-matched transmission frequency to the antenna; and
the duplexer for classifying the frequencies transmitted/received through the automatic matching module, at least one of transmitting the reception frequency, which is received from the automatic matching module, to the amplifier, and transmitting the transmission frequency, which is received from the amplifier, to the automatic matching module.

13. The apparatus as claimed in claim 12, further comprising a signal detection unit for determining a first operation state of the wireless terminal between the operation states of the wireless terminal, and the controller for determining the first operation state of the wireless terminal through a signal output from the signal detection unit.

14. The apparatus as claimed in claim 13, wherein the signal detection unit detects a voltage standing wave ratio (VSWR) signal comprising a magnitude signal and a phase signal received from the antenna.

15. The apparatus as claimed in claim 12, wherein the controller determines a second operation state of the wireless terminal between the operation states of the wireless terminal through a function operation of the wireless terminal for communication performance.

16. The apparatus as claimed in claim 15, wherein the second operation state comprises at least one of folder opening/closing, a hands free connection, a Bluetooth headset connection, key input and setup for automatic communication connection.

17. The apparatus as claimed in claim 12, further comprising a memory for storing an automatic matching table, and the automatic matching table stores an optimum antenna frequency signal value for automatic matching according to the operation states of the wireless terminal.

18. The apparatus as claimed in claim 13, wherein the controller determines the first operation state of the wireless terminal corresponding to the signal output from the signal detection unit through the automatic matching table, and controls the automatic matching module to automatically match the impedance for the transmission/reception frequencies of the antenna according to the first operation state of the wireless terminal.

19. The apparatus as claimed in claim 15, wherein the controller determines the second operation state of the wireless terminal through the automatic matching table, and controls the automatic matching module to automatically match the impedance for the transmission/reception frequencies of the antenna according to the second operation state of the wireless terminal.

20. The apparatus as claimed in claim 12, wherein the automatic matching module comprises a fixed inductor and a variable capacitor.

21. The apparatus as claimed in claim 12, wherein the amplifier comprises:
a first amplifier for amplifying and outputting a signal comprising the reception frequency received from the automatic matching module; and
a second amplifier for amplifying a signal comprising the transmission frequency and for transmitting the amplified signal to the automatic matching module.

22. An apparatus for automatically matching a frequency of an antenna in a wireless terminal receiving at least two communication services, the apparatus comprising:
a controller for determining states of the wireless terminal and for controlling an automatic matching module to automatically match impedance for transmission/reception frequencies of the antenna;
the automatic matching module for automatically matching impedance for the reception frequency received from the antenna, for transmitting the impedance-matched reception frequency to a switching module, for automatically matching impedance for a transmission frequency received from the switching module, and for transmitting the impedance-matched transmission frequency to the antenna;
the switching module for being switched to one of at least two communication service modules according to a type of a reception signal received in the antenna; and
said at least two communication service modules for transmitting/receiving a frequency of the antenna through the automatic matching module if said at least two communication service modules are linked with the automatic matching module through switching of the switching module.

23. The apparatus as claimed in claim 22, further comprising a signal detection unit for determining a first operation state of the wireless terminal between the operation states of the wireless terminal, and the controller for determining the first operation state of the wireless terminal through a signal output from the signal detection unit.

24. The apparatus as claimed in claim 23, wherein the signal detection unit detects a voltage standing wave ratio (VSWR) signal comprising a magnitude signal and a phase signal received from the antenna.

25. The apparatus as claimed in claim 22, wherein the controller determines a second operation state of the wireless terminal between the operation states of the wireless terminal through a function operation of the wireless terminal for communication performance.

26. The apparatus as claimed in claim 25, wherein the second operation state comprises at least one of folder opening/closing, a hands free connection, a Bluetooth headset connection, key input and setup for automatic communication connection.

27. The apparatus as claimed in claim 22, further comprising a memory for storing an automatic matching table, and the automatic matching table stores an optimum antenna frequency signal value for automatic matching according to the operation states of the wireless terminal.

28. The apparatus as claimed in claim 23, wherein the controller determines the first operation state of the wireless terminal corresponding to the signal output from the signal detection unit through the automatic matching table, and controls the automatic matching module to automatically match the impedance for the transmission/reception frequencies of the antenna according to the first operation state of the wireless terminal.

29. The apparatus as claimed in claim 25, wherein the controller determines the second operation state of the wireless terminal through the automatic matching table, and controls the automatic matching module to automatically match the impedance for the transmission/reception frequencies of the antenna according to the second operation state of the wireless terminal.

30. The apparatus as claimed in claim 22, wherein the automatic matching module comprises a fixed inductor and a variable capacitor.

31. The apparatus as claimed in claim 22, wherein the controller controls the switching module to be switched to one of said at least two communication service modules according to the type of the reception signal received in the antenna.

32. The apparatus as claimed in claim 22, wherein each of said at least two communication service modules comprises:
a duplexer for classifying the frequencies transmitted/received through the automatic matching module, transmitting the reception frequency, which is received from the automatic matching module, to the amplifier, and transmitting a transmission frequency, which is received from the amplifier, to the automatic matching module; and
the amplifier for amplifying and for outputting a signal comprising the reception frequency received from the duplexer, and amplifying a signal comprising the transmission frequency so as to transmit the amplified signal to the duplexer.

33. The apparatus as claimed in claim 32, wherein the amplifier comprises:
a first amplifier for amplifying and for outputting a signal comprising the reception frequency received from the automatic matching module; and
a second amplifier for amplifying a signal comprising the transmission frequency and for transmitting the amplified signal to the automatic matching module.

34. The apparatus as claimed in claim 17, wherein the controller determines the first operation state of the wireless terminal corresponding to the signal output from the signal detection unit through the automatic matching table, and controls the automatic matching module to automatically match the impedance for the transmission/reception frequencies of the antenna according to the first operation state of the wireless terminal.

35. The apparatus as claimed in claim 17, wherein the controller determines the second operation state of the wireless terminal through the automatic matching table, and controls the automatic matching module to automatically match the impedance for the transmission/reception frequencies of the antenna according to the second operation state of the wireless terminal.

36. The apparatus as claimed in claim 27, wherein the controller determines the first operation state of the wireless terminal corresponding to the signal output from the signal detection unit through the automatic matching table, and controls the automatic matching module to automatically match the impedance for the transmission/reception frequencies of the antenna according to the first operation state of the wireless terminal.

37. The apparatus as claimed in claim 27, wherein the controller determines the second operation state of the wireless terminal through the automatic matching table, and controls the automatic matching module to automatically match the impedance for the transmission/reception frequencies of the antenna according to the second operation state of the wireless terminal.

38. A method for automatically matching a frequency of an antenna in a wireless terminal, the method comprising:
classifying frequencies transmitted/received through the antenna of the wireless terminal;
transmitting a reception frequency received in the antenna to an automatic matching module and a transmission frequency, which is received from the automatic matching module, to the antenna;
matching impedance for the reception frequency received from the duplexer;
transmitting the impedance-matched reception frequency to an amplifier;
matching impedance for the transmission frequency received from the amplifier;
transmitting the impedance-matched transmission frequency to the duplexer; and
controlling the automatic matching module to automatically match the impedance for the transmission/reception frequencies.

39. A method for automatically matching a frequency of an antenna in a wireless terminal, the method comprising:
determining operation states of the wireless terminal and controlling an automatic matching module to automatically match impedance for transmission/reception frequencies of the antenna;
matching impedance for a reception frequency received from the antenna, transmitting the impedance-matched reception frequency to a duplexer, automatically matching impedance for a transmission frequency received from the duplexer, and transmitting the impedance-matched transmission frequency to the antenna; and
classifying the frequencies transmitted/received through the automatic matching module, and at least one of transmitting the reception frequency, which is received from the automatic matching module, to the amplifier, and transmitting the transmission frequency, which is received from the amplifier, to the automatic matching module.
